# EUROPEAN PATENT SPECIFICATION

(11) **EP 4 276 904 B1**
(45) Date of publication and mention of the grant of the patent: **07.05.2025**
(21) Application number: 22879561.3
(22) Date of filing: 17.06.2022
(51) Int. Cl.: H01L 27/02, H01L 29/78

(54) **ESD PROTECTION CIRCUIT, PROTECTION METHOD, SEMICONDUCTOR MEMORY, AND SYSTEM**
ESD-SCHUTZSCHALTUNG, SCHUTZVERFAHREN, HALBLEITERSPEICHER UND SYSTEM
CIRCUIT DE PROTECTION CONTRE LES DÉCHARGES ÉLECTROSTATIQUES, PROCÉDÉ DE PROTECTION, MÉMOIRE À SEMI-CONDUCTEURS ET SYSTÈME

(30) Priority: 01.04.2022 CN 202210348695
(43) Date of publication of application: 15.11.2023
(73) Proprietor: Changxin Memory Technologies, Inc., Hefei, Anhui 230601 (CN)
(72) Inventor: XUE, Zhan, Hefei, Anhui 230601 (CN); XU, Qian, Hefei, Anhui 230601 (CN); YANG, Hang, Hefei, Anhui 230601 (CN)
(74) Representative: Gulde & Partner
(86) International application number: PCT/CN2022/099585
(87) International publication number: WO 2023/184721

(56) References cited:
- CN-A- 107 564 902
- CN-A- 108 054 166
- US-A1- 2008 151 446
- US-A1- 2015 229 126
- US-B1- 6 514 839
- MING-DOU KER ED - VASSILIS PALIOURAS ET AL: "ESD (Electrostatic Discharge) Protection Design for Nanoelectronics in CMOS Technology", COMMUNICATIONS, ADVANCED SIGNAL PROCESSING, CIRCUITS, AND SYSTEM DESIG N TECHNIQUES FOR, IEEE, PI, 1 May 2006 (2006-05-01), pages 217 - 279, XP031019018, ISBN: 978-1-4244-0460-5
- VASSILEV V ET AL: "Snapback circuit model for cascoded NMOS ESD over-voltage protection structures", EUROPEAN SOLID-STATE DEVICE RESEARCH, 2003 33RD CONFERENCE ON. ESSDERC '03 SEPT. 16-18, 2003, PISCATAWAY, NJ, USA,IEEE, 16 September 2003 (2003-09-16), pages 561 - 564, XP032156313, ISBN: 978-0-7803-7999-2, DOI: 10.1109/ESSDERC.2003.1256938

## Description

### CROSS-REFERENCE TO RELATED APPLICATION

This application is filed based upon and claims priority to Chinese Patent Application No. 202210348695.7, filed on April 1, 2022 and entitled "ESD PROTECTION CIRCUIT, PROTECTION METHOD, SEMICONDUCTOR MEMORY AND SYSTEM".

### TECHNICAL FIELD

The present disclosure relates to the technical field of semiconductors, and in particular to, an Electro-Static Discharge (ESD) protection circuit, an ESD protection method, a semiconductor memory and an ESD protection system.

### BACKGROUND

The Electro-Static Discharge (ESD) in different degrees will occur in the manufacturing process of semiconductor memories and in the final system applications. The ESD is a common near-field hazard source, which can form high voltage, strong electric field and instantaneous large current, and the ESD is accompanied by strong electromagnetic radiation, and can form ESD electromagnetic pulse. When the ESD occurs, a large amount of charges are instantaneously poured from outside into the inside of a circuit of a memory, which will produce hundreds or even thousands of volts of high voltage and cause damage to the memory. Moreover, with the continuous reduction of the size of semiconductor memory, the memory is more vulnerable to the ESD.

US2018/0151446A1 discloses an electrostatic discharge (ESD) protection device and a layout thereof. A bias conducting wire is mainly used to couple each base of a plurality of parasitic transistors inside ESD elements together, in order to simultaneously trigger all the parasitic transistors to bypass the ESD current, avoid the elements of a core circuit being damaged, and solve the non-uniform problem of bypassing the ESD current when ESD occurs. Furthermore, in the ESD protection layout, it only needs to add another doped region on a substrate neighboring to, but not contacting, doped regions of the ESD protection elements and use contacts to connect the added doped region, so as to couple each base of the parasitic transistors together without requiring for additional layout area.

"ESD (Electrostatic Discharge) Protection Design for Nanoelectronics in CMOS Technology" discloses on-chip ESD protection designs for CMOS integrated circuits. The contents include (1) Introduction to Electrostatic Discharge, (2) Design Techniques of ESD Protection Circuit, (3) Whole-Chip ESD Protection Design, and (4) ESD Protection for Mixed- Voltage I/O Interface. The clear ESD protection design concepts and detailed circuit implementations are presented in this course. ESD protection design is more important in the nanoscale CMOS technology. High ESD robustness can not be achieved with only process solutions. The circuit design solutions should be added into the chips with suitable layout arrangement to achieve the purpose of whole-chip ESD protection for IC products.

"Snapback circuit model for cascaded NMOS ESD over-voltage protection structures" discloses an equivalent circuit snapback model for the ESD domain operation of merged cascaded NMOS devices. The model reflects the specific breakdown operation of the structure at different gate bias conditions. An example for optimization of the ESD behavior of an output driver, utilizing this protection device, is presented.

US2015/229126A1 discloses an electrostatic discharge (ESD) circuit for providing protection between a first node and a second node includes a first MOS device having a first source/drain coupled to a first node, and a second source/drain coupled to an intermediate node. The ESD circuit also includes a first capacitor coupled between a gate of the first MOS device and the first node, a first resistor coupled between the gate of the first MOS device the intermediate node, a second MOS device having a first source/drain coupled to the intermediate node, and a second source/drain coupled to the second node, a second capacitor coupled between a gate of the second MOS device and the first node, and a second resistor coupled between the gate of the second MOS device and the second node.

### SUMMARY

The present invention is set out in the set of appended claims .

Embodiments of the present disclosure provide an ESD protection circuit, an ESD protection method, a semiconductor memory and an ESD protection system. The ESD protection circuit includes a p-type substrate; a p-type well formed on the p-type substrate; a first NMOS transistor and a second NMOS transistor formed in the p-type well, where a drain of the first NMOS transistor is connected to a source of the second NMOS transistor; and a LDD region formed in proximity to a source of the first NMOS transistor. In this way, because the drain of the first NMOS transistor is connected to the source of the second NMOS transistor, the two NMOS transistors have a common active region, which is beneficial to the discharge of the ESD current. Moreover, the parasitic BJT can be triggered to be turned on through the substrate in the ESD protection circuit, so that the ESD current can be discharged through the parasitic BJT, and the electrostatic discharge ability of the ESD protection circuit can be further enhanced. In addition, in the ESD protection circuit, an LDD region is arranged only in proximity to the source of the first NMOS transistor, which can also reduce the leakage current of the ESD protection circuit in static working and reduce the power consumption.

### BRIEF DESCRIPTION OF THE DRAWINGS

FIG. 1 is a first schematic structural diagram of an ESD protection circuit according to an embodiment of the present disclosure.
FIG. 2 is a second schematic structural diagram of an ESD protection circuit according to an embodiment of the present disclosure.
FIG. 3 is a schematic structural diagram of an ESD protection circuit for forming a first discharging path according to an embodiment of the present disclosure.
FIG. 4 is a schematic structural diagram of an ESD protection circuit for forming a second discharging path according to an embodiment of the present disclosure.
FIG. 5 is a third schematic structural diagram of an ESD protection circuit according to an embodiment of the present disclosure.
FIG. 6 illustrates schematic structural diagrams of ESD protection circuits respectively having four LDD at different positions according to an embodiment of the present disclosure.
FIG. 7 illustrates electric field intensities distribution diagrams respectively corresponding to the four ESD protection circuits shown in FIG. 6 according to an embodiment of the present disclosure.
FIG. 8 is a flowchart of an ESD protection method according to an embodiment of the present disclosure.
FIG. 9 is a schematic structural diagram of a semiconductor memory according to an embodiment of the present disclosure.
FIG. 10 is a schematic structural diagram of an ESD protection system according to an embodiment of the present disclosure.

### DETAILED DESCRIPTION

The technical scheme in the embodiments of the present disclosure will be clearly and completely described below in conjunction with the drawings in the embodiment of the present disclosure. It can be appreciated that the specific embodiments described herein are intended only to explain the relevant disclosure and not to limit the disclosure. **In** addition it should be noted that for convenience of description, only portions related to the relevant disclosure are shown in the drawings.

Unless otherwise defined, all technical and scientific terms used herein have the same meaning as commonly understood by those skilled in the technical field of the present disclosure. The terms used herein is only for the purpose of describing the present disclosure, and is not intended to limit the present disclosure.

In the following description, "some embodiments" are referred to, which describe a subset of all possible embodiments, but it is understood that "some embodiments" may be the same subset or different subsets of all possible embodiments, and may be combined with each other without conflict.

The term "first\second\third" involved to in embodiments of the present disclosure is used for distinguishing similar objects and not representing a specific sequence or sequential order. It is to be understood that such used data may be interchangeable under an appropriate circumstance, so that the embodiments of the present disclosure described herein are, for example, capable of being implemented in a sequence other than those illustrated or described herein.

The ESD in different degrees will occur in the manufacturing process of semiconductor memory and in the final system application. The ESD is easy to cause damage to the memory. Therefore, it is necessary to add circuit design of ESD protection to the memory to protect the memory from ESD damage.

Based on this, the embodiments of the present disclosure provides an ESD protection circuit, including a p-type substrate; a p-type well formed on the p-type substrate; a first NMOS transistor and a second NMOS transistor formed in the p-type well, where a drain of the first NMOS transistor is connected to a source of the second NMOS transistor; and a LDD region formed in proximity to a source of the first NMOS transistor. In this way, because the drain of the first NMOS transistor is connected to the source of the second NMOS transistor, the two NMOS transistors have a common active region, which is beneficial to the discharge of the ESD current. Moreover, the parasitic BJT can be triggered to be turned on through the substrate in the ESD protection circuit, so that the ESD current can be discharged through the parasitic BJT, and the electrostatic discharge ability of the ESD protection circuit can be further enhanced. In addition, in the ESD protection circuit, an LDD region is arranged only in proximity to the source of the first NMOS transistor, which can also reduce the leakage current of the ESD protection circuit in static working and reduce the power consumption.

Embodiments of the present disclosure will be described in detail below with reference to the accompanying drawings.

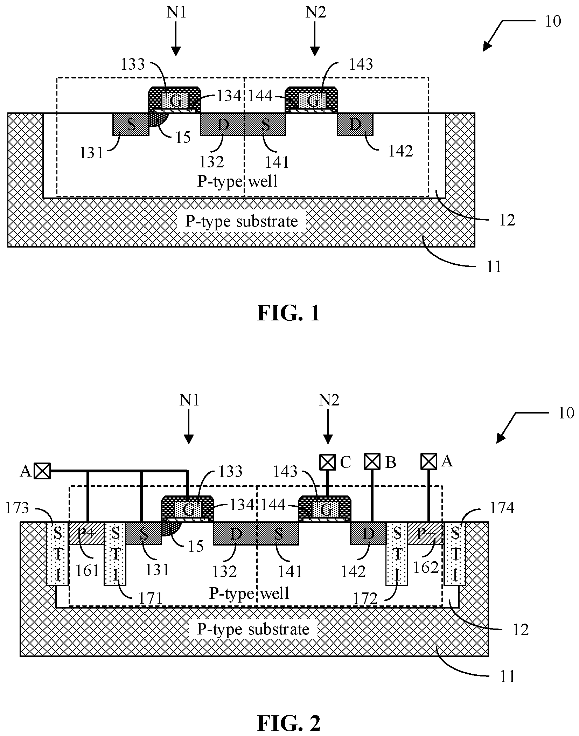

In an embodiment of the present disclosure, with reference to FIG. 1, a first schematic structural diagram of an ESD protection circuit according to an embodiment of the present disclosure is shown. As shown in FIG. 1, the ESD protection circuit 10 includes a p-type substrate 11, a p-type well 12, a first NMOS transistor N1 and a second NMOS transistor N2, and a LDD region 15.

The P-type well 12 is formed on the P-type substrate 11.

The first NMOS transistor N1 and the second NMOS transistor N2 are formed in the P-type well 12. A drain 132 of the first NMOS transistor N1 is connected to a source 141 of the second NMOS transistor N2.

The LDD region 15 is formed in proximity to a source 131 of the first NMOS transistor N1.

It should be noted that, FIG. 1 is a schematic diagram of a cross-sectional structure of an ESD protection circuit 10 according to an embodiment of the present disclosure. The ESD protection circuit 10 can be formed in a semiconductor memory for protecting the memory to prevent the memory from being damaged by the ESD. As shown in FIG. 1, the p-type well 12 is formed on the p-type substrate 11, and two NMOS transistors, respectively the first NMOS transistor N1 and the second NMOS transistor N2, are formed in the P-type well 12 to realize the ESD protection.

It should be further noted that, in the ESD protection circuit 10 shown in FIG. 1, the drain (D) 132 of the first NMOS transistor N1 is connected to the source (S) 141 of the second NMOS transistor N2. That is to say, for the first NMOS transistor N1 and the second NMOS transistor N2, both of them have the common active region, and the drain 132 of the first NMOS transistor N1 is the source 141 of the second NMOS transistor N2, i.e., a stacked NMOS transistor structure is formed. In this way, when the ESD current is discharged through the first NMOS transistor N1 and the second NMOS transistor N2, due to the connection between the drain 132 and the source 141, the resistance is small and it facilitates the discharge of the ESD current.

The first NMOS transistor N1 and the second NMOS transistor N2 each include a gate. As shown in FIG. 1, a gate oxide layer 134 is formed on the p-type well disposed between the source 131 of the first NMOS transistor N1 and the drain 132 of the first NMOS transistor N1, a gate (G) 133 of the first NMOS transistor N1 is formed on the gate oxide layer 134, and a side wall may be formed around the gate 133. A gate oxide layer 144 is formed on the p-type well disposed between the source 141 of the second NMOS transistor N2 and the drain 142 of the second NMOS transistor N2, a gate 143 of the second NMOS transistor N2 is formed on the gate oxide layer 144, and a side wall may be formed around the gate 143.

It should also be noted that the LDD region is a low-doped drain region arranged in the channel of an MOS transistor, which can also bear a part of the voltage, so that the hot electron degradation effect can be effectively prevented.

In some embodiments, with reference with FIG. 2, a second schematic structural diagram of an ESD protection circuit according to an embodiment of the present disclosure is shown. As shown in FIG. 2 the ESD protection circuit 10 may further include a first p+ doped region 161 and a second p+ doped region 162 that are formed in the p-type well 12. The first p+ doped region 161 is disposed on a side of the source 131 of the first NMOS transistor N1, which is far away from the drain 132 of the first NMOS transistor N1, and the second p+ doped region 162 is disposed on a side of the drain 142 of the second NMOS transistor N2, which is far away from the source 141 of the second NMOS transistor N2. It will be known to those skilled in the art that the doping concentration of the p+ doped region is higher than the doping concentration of the p-type well 12.

It should be noted that, as shown in FIG. 2, the first p+ doped region 161 may be disposed in proximity to the source 131 of the first NMOS transistor N1 and away from the drain 132 of the first NMOS transistor N1, and the second p+ doped region 162 may be disposed in proximity to the drain 142 of the second NMOS transistor N2 and away from the source 141 of the second NMOS transistor N2.

In some embodiments, as shown in FIG. 2, a first Shallow Trench Isolation (STI) structure 171 is formed between the first p+ doped region 161 and the source 131 of the first NMOS transistor N1.

A second STI structure 172 is formed between the second p+ doped region 162 and the drain 142 of the second NMOS transistor N2.

It should be noted that, the first STI structure 171 is used for insularly isolating the source 131 of the first NMOS transistor N1 from the first p+ doped region 161, and the second STI structure 172 is used for insularly isolating the drain 142 of the second NMOS transistor N2 from the second p+ doped region 162. The insularly isolation is performed through STI structure can avoid leakage between the doped regions.

In addition, as shown in FIG. 2, the ESD protection circuit 10 may also include a third STI structure 173 formed between the first p+ doped region 161 and the p-type substrate 11; and a fourth STI structure 174 formed between the second p+ doped region 162 and the p-type substrate 11. In this way, the first NMOS transistor N1 and the second NMOS transistor N2 are insularly isolated from other components (not shown) in the circuit by the third STI structure 173 and the fourth STI structure 174, to avoid crosstalk between the components.

In some embodiments, as shown in FIG. 2, the ESD protection circuit 10 is provided with a first power supply terminal A, a second power supply terminal B and a third power supply terminal C.

A gate 133 of the first NMOS transistor N1, the source 131 of the first NMOS transistor N1, the first p+ doped region 161 and the second p+ doped region 162 are all connected to the first power supply terminal A.

The drain 142 of the second NMOS transistor N2 is connected to the second power supply terminal B.

A gate 143 of the second NMOS transistor N2 is connected to the third power supply terminal C.

It should be noted that, the first power supply terminal A is usually a ground terminal, i.e., in the ESD protection circuit 10, the gate 133 of the first NMOS transistor N1, the source 131 of the first NMOS transistor N1, the first p+ doped region 161 and the second p+ doped region 162 are all grounded or connected to a low level meeting the potential demand. The second power supply terminal B is usually an external power supply terminal or an Input/Output (I/O) port, and connected to the drain 142 of the second NMOS transistor N2. The second power supply terminal B is a discharge terminal for discharging the ESD current or connected to the discharge terminal for discharging the ESD current. The third power supply terminal C is connected to the gate 143 of the second NMOS transistor N2 and is a control terminal of the second NMOS transistor N2. By controlling the voltage at the third power supply terminal C, the second NMOS transistor N2 can be controlled to be turned on or turned off, and the conduction degree when the second NMOS transistor N2 is controlled to be turned on can be controlled.

It should be further noted that, in the ESD protection circuit 10, two discharging paths for discharging the ESD current are formed, i.e., a first discharging path and a second discharging path.

The first discharging path represents a path formed by a channel of the second NMOS transistor and a parasitic BJT of a first NMOS transistor.

The second discharging path represents a path formed by the target parasitic BJT.

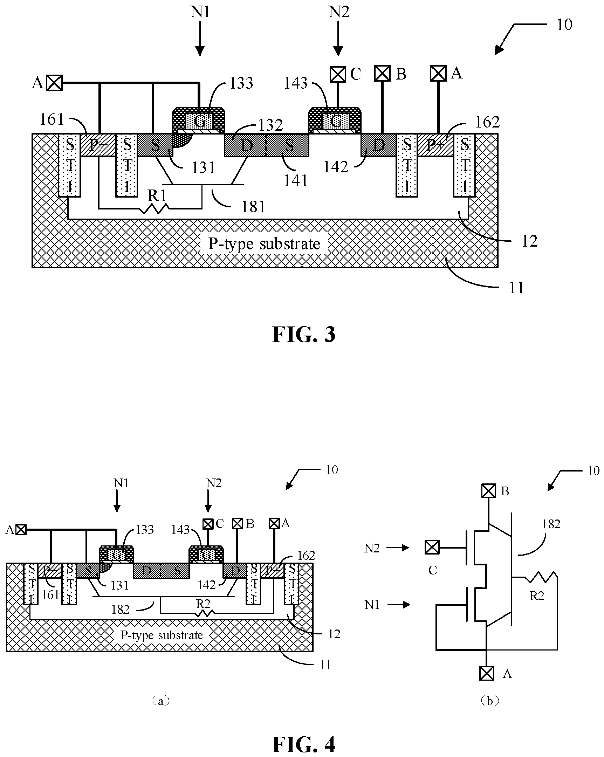

It should be noted that, for the first discharging path, with reference to FIG. 3, a schematic structural diagram of an ESD protection circuit for forming a first discharging path according to an embodiment of the present disclosure is shown. As shown in FIG. 3, when the ESD current is discharged through the first discharging path, the ESD current is firstly discharged from the drain 142 of the second NMOS transistor N2 to the source 141 of the second NMOS transistor N2 via the channel of the second NMOS transistor N2. Since the drain 132 of the first NMOS transistor N1 is connected to the source 141 of the second NMOS transistor N2, the voltage at the drain 132 is increased, thereby turning on the parasitic BJT 181 formed between the source 131 and the drain 132 of the first NMOS transistor. A base of the parasitic BJT 181 is connected to a parasitic resistor R1 and connected to the first p+ doped region 161 through the parasitic resistor R1, and then connected to the first power supply terminal A. An emitter of the parasitic BJT 181 is connected to the drain 132 of the first NMOS transistor N1. A collector of the parasitic BJT 181 is connected to the source 131 of the first NMOS transistor N1. In this way, after passing through the channel of the second NMOS transistor N2, the ESD current is discharged to the source 131 of the first NMOS transistor through the parasitic BJT 181, and finally discharged to the first power supply terminal A, i.e., discharged to the ground terminal.

It can be seen that in the first discharging path, the channel of the first NMOS transistor N1 does not function, and the ESD current is discharged through the p-type well 12 below the first NMOS transistor N1. In this way, the ESD current can be discharged through the channel of the second NMOS transistor N2 and the parasitic BJT 181, so that an ESD protection can be realized. In addition, the voltages at the gate of the second NMOS transistor N2 (that is, the voltages at the third power supply terminal C) are different), and the corresponding channel widths of the second NMSO transistor N2 are also different. The larger the channel width, the faster the discharge speed, and the more beneficial it is to realize the ESD protection of the high-voltage power supply, i.e., more charges can be discharged within a certain period of time.

For the second discharging path, with reference to FIG. 4, a schematic structural diagram of an ESD protection circuit for forming a second discharging path according to an embodiment of the present disclosure is shown. In FIG. 4, (a) is a cross-sectional schematic diagram of the ESD protection circuit, and (b) is a schematic structural diagram of the corresponding circuit. As shown in FIG. 4, the ESD protection circuit 10 further includes a target parasitic BJT 182 formed in the p-type well 12.

The base of the target parasitic BJT 182 is connected to one end of a parasitic resistor R2, and the other end of the parasitic resistor is connected to the second p+ doped region 162.

An emitter of the target parasitic BJT 182 is connected to the drain 142 of the second NMOS transistor N2.

A collector of the target parasitic BJT 182 is connected to the source 131 of the first NMOS transistor N1.

It should be noted that, as shown in FIG. 3, for the ESD protection circuit 10 provided in the embodiments of the present disclosure, the target parasitic BJT 182 is further formed in the p-type well. The base of the target parasitic BJT 182 is connected to one end of the parasitic resistor R2, the emitter of the target parasitic BJT 182 is connected to the drain 142 of the second NMOS transistor N2, and the collector of the target parasitic BJT 182 is connected to the source 131 of the first NMOS transistor N1. The ESD current may be discharged from the drain 142 of the second NMOS transistor N2 to the source 131 of the first NMOS transistor N1 via the target parasitic BJT 182, and finally discharged to the first power supply terminal A, i.e. discharged to the ground terminal.

That is to say, in the second discharging path, the channel of the first NMOS transistor N1 and the channel of the second NMOS transistor N2 do not functions, and the ESD current is discharge directly from the p-type well 12 through the target parasitic BJT 182. In this way, not only can the ESD current be quickly discharged, but the risk that the gate oxide layer 144 of the second NMOS transistor N2 will be damaged by a large current when the ESD current is too large can be avoided, since the ESD current is discharged from the p-type well 12 with a large area instead of being discharged through the channel of the second NMOS transistor N2 with a small area.

It can be seen that in the ESD protection circuit 10 provided in the embodiments of the present disclosure, there are two paths for discharging the ESD current so that the discharge of the ESD current can be implemented through multiple paths. For the first discharging path, because the ESD current is firstly discharge through the channel of the second NMOS transistor N2, when the ESD current is too large, the gate oxide layer 144 may be broken down and the second NMOS transistor may be damaged. Therefore, according to the embodiments of the present disclosure, ESD current can also be discharged through the second discharging path, so that not only the ESD current can be discharged, but also device damage caused by excessive current can be avoided.

In practical application, the first discharging path and the second discharging path can be simultaneously turned on to discharge the ESD current, and an appropriate discharging path can be selected according to the magnitude of the ESD current to discharge the ESD current. Generally, an appropriate discharging path can be selected according to the voltage at the second power supply terminal B.

In some embodiments, the first discharging path is in a working state when the voltage at the second power supply terminal B is less than a preset voltage.

The second discharging path is in a working state when the voltage at the second power supply terminal B is greater than or equal to the preset voltage.

It should be noted that, the second power supply terminal B is an ESD discharge terminal or connected with the ESD discharge terminal. When the voltage at the second power supply terminal B is lower than the preset voltage, the ESD current is discharged through the first discharging path (i.e., the second NMOS transistor N2 and the parasitic BJT 181); and when the voltage at the second power supply terminal B is higher than the preset voltage, the target parasitic BJT 182 can be triggered to be turned on, so that the ESD current directly flows to the source 131 of the first NMOS transistor through the drain 142 of the second NMOS transistor N2 and the p-type well 12, and the ESD current is discharged through the second discharging path. Compared with the discharge of the ESD current through the second MOS transistor N2 and the parasitic BJT 181, the discharge of the ESD current through the target parasitic BJT 182 is beneficial to avoiding the voltage drop caused by the threshold voltage limiting the discharge current, so that the ESD current can be discharged more quickly.

The preset voltage represents the voltage at the second power supply terminal B when the second discharging path participates in the discharge of ESD current, and the preset voltage is associated with the resistance of the parasitic resistor R2.

In some embodiments, the resistance of the parasitic resistor is associated with a length of a path between the drain 142 of the second NMOS transistor N2 and the second p+ doped region 162.

It should be noted that the magnitude of the preset voltage is associated with a length of the path between the drain 142 of the second NMOS transistor N2 and the second p+ doped region 162. The path can be equivalent to the parasitic resistor R2. The longer the path, the greater the resistance of the parasitic resistor R2, the greater the partial voltage of the path, and the smaller the preset voltage. Similarly, the shorter the path, the smaller the resistance of the parasitic resistor R2, the smaller the partial voltage of the path, and the larger the preset voltage.

Therefore, in the process of preparing the ESD protection circuit, the resistance of the parasitic resistor R2 can be changed by adjusting the length of the path between the drain 142 of the second NMOS transistor N2 and the second p+ doped region 162, thereby adjusting the preset voltage.

Furthermore, for the path in some embodiments, the length of the path is associated with a depth of the second STI structure 172.

It should be noted that the length of the path between the drain 142 of the second NMOS transistor N2 and the second p+ doped region 162 is associated with a depth of the second STI structure 172. Specifically, as the depth of the second STI structure 172 increases, the length of the path increases; and when the depth of the second STI structure 172 decreases, the length of the path decreases.

That is to say, the deeper the depth of the second STI structure 172, the longer the length of the path between the drain 142 of the second NMOS transistor N2 and the second p+ doped region 162, so that the resistance of the equivalent resistance is larger; and the shallower the depth of the second STI structure 172, the shorter the length of the path between the drain 142 of the second NMOS transistor N2 and the second p+ doped region 162, so that the resistance of the equivalent resistance is smaller.

Therefore, in the process of preparing the ESD protection circuit, the length of the path between the drain 142 of the second NMOS transistor N2 and the second p+ doped region 162 can be changed by adjusting the depth of the second STI structure 172, thereby changing the resistance of the equivalent resistance and further adjusting the preset voltage.

In some embodiments, the voltage at the third power supply terminal C is used for adjusting the conduction degree of the second NMOS transistor N2 when the first discharging path is in a working state, and the amount of carriers transmitted by the first discharging path is controlled according to the conduction degree of the second NMOS transistor N2.

It should be noted that the third power supply terminal C is connected to the gate 143 of the second NMOS transistor, so that the conduction degree of the second NMOS transistor N2 can be adjusted based on the voltage at the third power supply terminal C, and further the amount of carriers transmitted by the first discharging path can be controlled based on the conduction degree of the second NMOS transistor N2.

Furthermore, when the voltage at the third power supply terminal C increases, the conduction degree of the second NMOS transistor N2 is increased so that the amount of carriers transmitted by the first discharging path increases to decrease the amount of carriers transmitted by the second discharging path.

It should be noted that, the conduction degree of the second NMOS transistor N2 can be controlled by controlling the voltage at the third power supply terminal C. When the voltage at the third power supply terminal C increases, the conduction degree of the second NMOS transistor N2 increases, so that carriers at the drain 142 of the second NMOS transistor are more easily transmitted to the source 131 of the first NMOS transistor N1 through the channel of the second NMOS transistor and the parasitic BJT 181, so that ESD current is discharged more through the first discharging path. Moreover, fewer carriers will be injected into the base region of the target parasitic BJT 182, so that a higher resistance at the base region can be maintained to suppress the latch-up.

It can be seen that the main discharging path can be controlled by the third power supply terminal C, and the larger the voltage at the third power supply terminal C, the larger the preset voltage is needed to switch to the second discharging path. When the voltage at the second power supply terminal B is less than the preset voltage, ESD current is discharged through the channel of the second NMOS transistor N2 and the parasitic BJT 181 of the first NMOS transistor N1. When the voltage at the second power supply terminal B is greater than or equal to the preset voltage, the ESD current is discharged directly through the parasitic BJT 182 between the source 131 and the drain 142, and the channel of the second NMOS transistor N2 does not function.

Furthermore, the voltage at the third power supply terminal C is also used for adjusting the trigger voltage and the maintenance voltage. The trigger voltage and the maintenance voltage corresponding to the first discharging path are different from the trigger voltage and the maintenance voltage corresponding to the second discharging path.

It should be noted that, according to the embodiments of the present disclosure, the voltage at the third power supply terminal C can be adjusted to adjust the participation degree of the first discharging path and the second discharging path during ESD current discharge, and further the first discharging path or the second discharging path can be selected as the ESD current discharging path through the voltage at the third power supply terminal C. The first discharging path and the second discharging path have different trigger voltages and maintenance voltages, and therefore, according to the embodiments of the present disclosure, the trigger voltage and maintenance voltage can also be adjusted by the voltage at the third power supply terminal C.

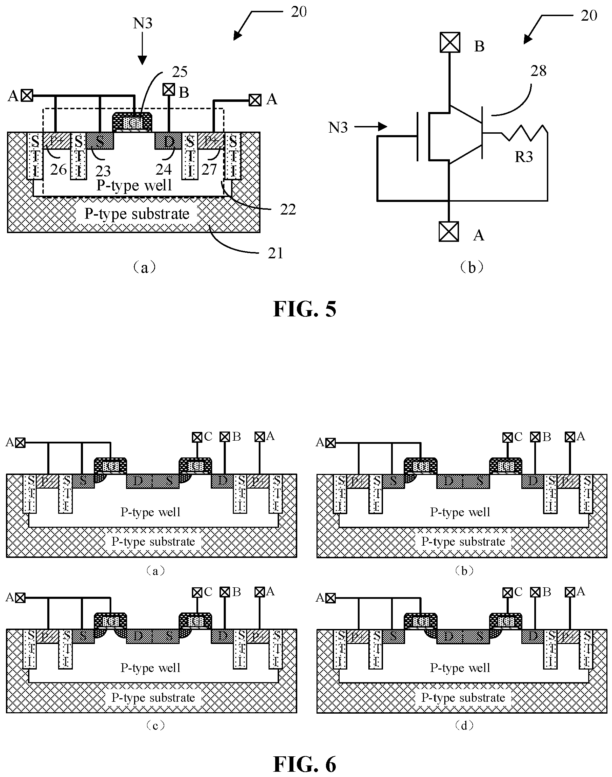

In addition, for comparison, with reference to FIG. 5, a third schematic structural diagram of an ESD protection circuit according to an embodiment of the present disclosure is shown. In FIG. 5, (a) is a cross-sectional schematic diagram of the ESD protection circuit 20, and (b) is a schematic structural diagram of the ESD protection circuit 20 formed with a parasitic BJT 28. As shown in FIG. 5, the ESD protection circuit 20 includes a p-type substrate 21; a p-type well 22 formed in the p-type substrate 21; an NMOS transistor N3 formed in the p-type well 22; a p+ doped region 26 formed in proximity to the source 23 of the NMOS transistor N3, a p+ doped region 27 formed in proximity to the drain 24 of the NMOS transistor N3; and four STI structures used as insularly isolation.

The source 23 and the gate 25 of the NMOS transistor N3, the p+ doped region 26 and the p+ doped region 27 are all connected to the first power supply terminal A (ground terminal), and the drain 24 of the NMOS transistor N3 is connected to a second power supply terminal B. When the parasitic BJT 28 is triggered to be turned on, the ESD current is discharged from the drain 24 to the source 23 via the parasitic BJT 28, and then discharged to the ground.

The ESD protection circuit 10 in FIG. 4 is compared with the ESD protection circuit 20 in FIG. 5, it can be seen that there are two discharging paths in the ESD protection circuit 10, and one discharging path or both can be flexibly selected to discharge the ESD current based on actual demands. In the first discharging path, the discharge is implemented by combining the channel of the second NMOS transistor N2 and the parasitic BJT 181. In the second discharging path, the ESD current is discharge through the p-well 12. In this case, the base region is larger and has a good heat dissipation effect, which is more beneficial to discharge. In the ESD protection circuit 20, ESD protection can also be realized, but there is only one discharging path, i.e., the parasitic BJT 28, and the base region is small, therefore, when the ESD current is large, it is likely to cause device to be broken down and damage the circuit. Therefore, the ESD protection circuit 10 has a better ESD protection effect.

Furthermore, for the LDD region, in some embodiments, the ESD protection circuit has one LDD region and the LDD region 121 is formed in proximity to the source 131 of the first NMOS transistor N1. In this way, since only one LDD region 15 is provided in proximity to the source 131 of the first NMOS transistor N1, the leakage current of the ESD protection circuit 10 in the static working can be reduced, thereby reducing the power consumption.

It should be noted that, with reference to FIG. 6, schematic diagrams of ESD protection circuits 10 respectively having four LDD at different positions according to an embodiment of the present disclosure are shown. As shown in FIG. 6, the structures of the ESD protection circuit 10 in (a), (b), (c) and (d) are substantially identical, except that: the ESD protection circuit 10 in (a) includes two LDD regions respectively formed in proximity to the source of the first NMOS transistor and in proximity to the source of the second NMOS transistor; the ESD protection circuit 10 in (b) only includes one LDD region formed in proximity to the source of the first NMOS transistor, and the ESD protection circuit 10 in (b) is the ESD protection circuit 10 shown in FIG. 2; the ESD protection circuit 10 in (c) includes three LDD regions respectively formed in proximity to the source and drain of the first NMOS transistor and in proximity to the source of the second NMOS transistor; the ESD protection circuit 10 in (d) includes two LDD regions respectively formed in proximity to the drain of the first NMOS transistor and in proximity to the source electrode of the second NMOS transistor.

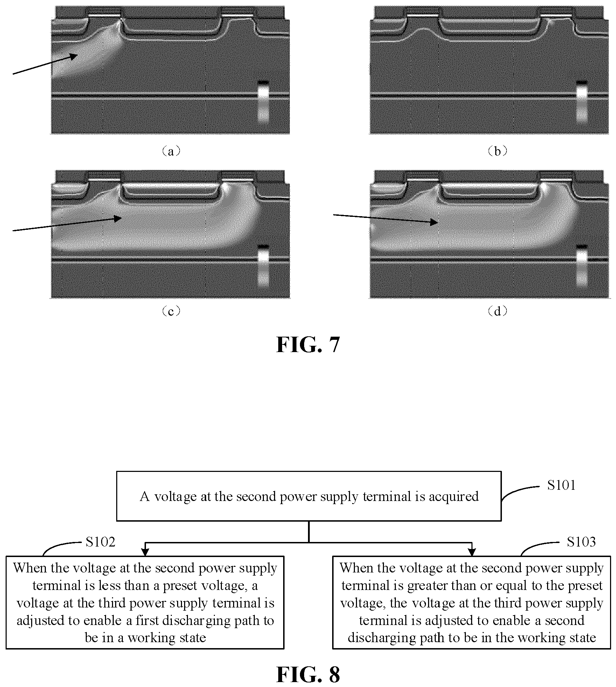

For the four ESD protection circuits 10 shown in FIG. 6, electric field intensities of the four ESD protection circuits 10 during static working are detected respectively. With reference to FIG. 7, electric field intensity distribution diagrams respectively corresponding to the four ESD protection circuits shown in FIG. 6 according to an embodiment of the present disclosure are shown, where (a), (b), (c) and (d) in FIG. 7 respectively correspond to (a), (b), (c) and (d) in FIG. 6. As shown in FIG. 7, the light-colored area indicated by the arrow is the electric field distribution of the ESD protection circuit 10. It can be seen from FIG. 7 that under the static working condition, strong electric fields are generated in (c) and (d), and although the electric field generated in (a) is weaker than that of (c) and (d), a strong electric field still exists; but in (b), there is almost no electric field, resulting in the least leakage current.

Taking the comparison between two LDD regions and one LDD region as an example, when there are LDD regions, the length of the channel of NMOS transistor is shorter and the threshold voltage is smaller, so that the NMOS transistor is prone to leakage current. Generally speaking, the more the number of LDD regions, the shorter the channel, the smaller the threshold voltage and the larger the leakage current. In addition, the closer the LDD region is to the discharge terminal, the stronger the electric field is. In a case where the voltage at the third power supply terminal C is constant, after the LDD region is reduced, the voltage at the second power supply terminal B may need to be larger before it can start to discharge, which can be solved by increasing the voltage at the third power supply terminal C at this time. In addition, increasing the voltage at the third power supply terminal C can also reduce the voltage difference at the terminal B and the terminal C during the discharge, thus avoiding the gate dielectric layer/gate oxide layer from being broken down.

Furthermore, with reference to Table 1, which shows the magnitude of the leakage current (in amperes, A) generated by the four ESD protection circuits 10 in FIG. 6 (a), (b), (c) and (d) when the first power supply terminal A is at different voltages (VA).

**Table 1**

| | Leakage current (ampere) | | |
|---|---|---|---|
| Voltage | VA=0 V | VA=3 V | VA=6 V |
| (a) | 5.14E⁻¹⁷ | 1.12E⁻⁹ | 1.74E⁻⁹ |
| (b) | 1.34E⁻¹⁷ | 1.77E⁻¹⁰ | 9.46E⁻¹⁰ |
| (c) | 2.84E⁻¹⁷ | 4.36E⁻⁹ | 4.84E⁻⁹ |
| (d) | 3.54E⁻¹⁷ | 4.42E⁻⁹ | 4.9E⁻⁹ |

As can be seen from the combination of FIG. 7 and Table 1, regardless of the voltage, the leakage current generated in the ESD protection circuit in (b) is the least, especially at the voltages of 3 V and 6 V, and the leakage current generated in (b) is different from leakage currents of other circuits by an order of magnitude. It can be seen that when the LDD is arranged only in proximity to the source of the first NMOS transistor, almost no electric field is generated by the ESD protection circuit 10 in the static working, which effectively reduces the leakage current generated by the ESD protection circuit 10 in the static working, thereby reducing the power consumption.

It should be noted that only the LDD region 15 in proximity to the source 131 of the first NMOS transistor N1 is retained in the embodiments of the present disclosure. On the one hand, since the LDD region 15 is grounded, the electric field will not be too strong, which is beneficial to enhancing the discharge capacity.

On the other hand, reducing the number of the LDD regions can increase the threshold voltage, thereby reducing the subthreshold leakage current of the drain 142 of the second NMOS transistor N2 during static working; reducing the voltage transmitted from the drain 142 of the second NMOS transistor N2 to the source 141 of the second NMOS transistor N2; and thereby reducing the Gate-Induced Drain Leakage (GIDL) of the source 141 of the second NMOS transistor N2 during static working.

On the yet other hand, reducing the number of the LDD regions can also inhibit the discharge of LDD and avoid the damage of gate oxide layer caused by the discharge of LDD.

In short, according to the embodiments of the present disclosure, the MOS transistor stacked structure is used for enabling the drain (drain terminal) 132 of the first NMOS transistor N1 to be the source (source terminal) 141 of the second NMOS transistor N2, therefore, the two NMOS transistors have a common active region, which can enhance the ESD protection capability. According to the embodiments of the disclosure, an ESD discharging path is also formed through a substrate trigger process, and the ESD protection device formed by the substrate trigger is beneficial to realizing better ESD protection. According to the embodiment of the present disclosure, the trigger voltage and the maintenance voltage also can be adjusted by controlling the voltage at the gate (the third power supply terminal C) of the second NMOS transistor N2, and an appropriate maintenance voltage can be designed according to the demand to prevent the risk of latch-up. In addition, According to the embodiments of the present disclosure, by adjusting the position of the LDD region, the leakage current of the memory in static working and the power consumption can be effectively reduced, and the robustness of ESD protection can be enhanced.

Embodiments of the present disclosure provide an ESD protection circuit. The ESD protection circuit can be applied to the field of Dynamic Random Access Memory (DRAM), to realize ESD protection of high-voltage power supply. In the stacked NMOS transistors, the target parasitic BJT is turned on by substrate trigger process to discharge the ESD current, and the polarity of gate voltage can be adjusted, so as to achieve ESD protection for different high-voltage power supplies. Two discharging paths can be formed through the stacked NMOS transistors to realize adjustable trigger voltage and maintenance voltage. By adjusting the position of LDD, the leakage in static working and the power consumption can be effectively reduced, and the robustness can be enhanced.

Based on the ESD protection circuit 10 provided by the foregoing embodiments, another embodiment of the present disclosure also provides an ESD protection method. With reference to FIG. 8, a flowchart of an ESD protection method according to an embodiment of the present disclosure is shown. As shown in FIG. 8, the method includes operations S101 to S103:

In operation S101, a voltage at the second power supply terminal is acquired.

In operation S102, when the voltage at the second power supply terminal is less than a preset voltage, a voltage at the third power supply terminal is adjusted to enable a first discharging path to be in a working state.

In operation S103, when the voltage at the second power supply terminal is greater than or equal to the preset voltage, the voltage at the third power supply terminal is adjusted to enable a second discharging path to be in the working state.

The first discharging path represents a path formed by a channel of the second NMOS transistor and a parasitic BJT between a source and a drain of a first NMOS transistor; and the second discharging path represents a path formed by the target parasitic BJT between the source of the first NMOS transistor and a drain of the second NMOS transistor.

It should be noted that the ESD protection method provided by the embodiments of the present disclosure is applied to the ESD protection circuit 10 provided by the foregoing embodiments. With reference to FIG. 1 to FIG. 4, the ESD protection circuit 10 includes the p-type substrate 11; the p-type well 12 formed on the p-type substrate; a first NMOS transistor N1 and a second NMOS transistor N2 formed in the p-type well 12, where the drain 132 of the first NMOS transistor N1 is connected to the source 141 of the second NMOS transistor N2; and a LDD region 15 formed in proximity to the source 131 of the first NMOS transistor N1.

The ESD protection circuit 10 further includes the first p+ doped region 161 and a second p+ doped region 162 that are formed in the p-type well 12, where the first p+ doped region 161 is disposed in proximity to the source 131 of the first NMOS transistor N1, and the second p+ doped region 162 is disposed in proximity to a drain 142 of the second NMOS transistor N2. The first STI structure 171 is formed between the first p+ doped region 161 and the source 131 of the first NMOS transistor N1; and a second STI structure 172 is formed between the second p+ doped region 162 and the drain 142 of the second NMOS transistor N2.

The ESD protection circuit 10 may also be provided with three power supply terminals: the first power supply terminal A, the second power supply terminal B, and the third power supply terminal C. In the ESD protection circuit 10, the second power supply terminal B is a discharge terminal for discharging the ESD current or is connected to the discharge terminal for discharging the ESD current.

According to the embodiments of the present disclosure, the voltage at the power supply terminal C can be can adjusted according to the magnitude relationship between the voltage at the second power supply terminal B and the preset voltage, so that the ESD circuit can perform the discharg through different discharging paths. Specifically, when the voltage at the second power supply terminal B is less than the preset voltage, the ESD current generated is small at this time, and the first discharging path is sufficient to meet the discharge demand. At this time, the voltage at the third power supply terminal can be appropriately increased, thereby increasing the conduction degree of the second NMOS transistor N2, so that the first discharging path is in a working state, and the ESD current can be discharge through the channel of the second NMOS transistor N2 and the parasitic BJT 181 of the first NMOS transistor N1. The parasitic BJT 181 is formed between the source 131 and the drain 132 of the first NMOS transistor, so that the ESD current transmitted from the channel of the second NMOS transistor N2 can flow through the p-type well and the parasitic BJT 181 and then be discharged from the drain 132 of the first NMOS transistor to the source 131 of the first NMOS transistor.

When the voltage at the second power supply terminal B is greater than or equal to the preset voltage, the ESD current is large at this time, and the discharge speed may be slow when discharging through the first discharging path. At this time, the voltage at the third power supply terminal C can be appropriately reduced, thereby reducing the conduction degree of the second NMOS transistor N2, so that the second discharging path is in a working state, and most of the ESD current can be discharged through the target parasitic BJT 182, so as to improve the discharge speed and avoid the threshold voltage and channel width of the second NMOS transistor N2 limiting the discharge speed of the ESD current. It should be noted that the control voltage at the third power supply terminal C cannot be too small, so as to avoid the breakdown of the gate dielectric layer of the second NMOS transistor N2 due to the excessive voltage difference between the second power supply terminal B and the third power supply terminal C. The target parasitic BJT 182 is formed between the source 131 of the first NMOS transistor N1 and the drain 142 of the second NMOS transistor N2, so that the ESD current can flow through the p-type well and through the target parasitic BJT 182, i.e., the ESD current can be discharged from the drain 142 of the second NMOS transistor N2 to the source 131 of the first NMOS transistor N1.

That is to say, the second discharging path is mainly composed of the target parasitic BJT 182 formed in the P-type well 12. The base of the target parasitic BJT 182 is connected to one end of a parasitic resistor R2, and the other end of the parasitic resistor is connected to the second p+ doped region 162; the emitter of the target parasitic BJT 182 is connected to the drain 142 of the second NMOS transistor N2; and the collector of the target parasitic BJT 182 is connected to the source 131 of the first NMOS transistor N1.

Thus, based on the voltage variation at the second power supply terminal B, an appropriate discharging path is flexibly selected to discharge the ESD current, which not only realizes ESD protection, but also avoids damaging the device in the ESD protection circuit 10.

In some embodiments, when the voltage at the third power supply terminal increases, the conduction degree of the second NMOS transistor N2 is increased so that the amount of carriers transmitted by the first discharging path increases to decrease the amount of carriers transmitted by the second discharging path.

It should be noted that when the voltage at the third power supply terminal C is increased, the conduction degree of the second NMOS transistor is increased, so that the first discharging path can transmit more carriers and the amount of carriers transmitted by the second discharging path is reduced. When the voltage at the third power supply terminal C is reduced, the conduction degree of the second NMOS transistor is reduced, so that the second discharging path can transmit more carriers, and the amount of carriers transmitted by the first discharging path is reduced.

In some embodiments, the method may further include:

Regulating the trigger voltage and the sustain voltage through the voltage at the third power supply terminal C; The trigger voltage and the sustain voltage corresponding to the first discharging path are different from the trigger voltage and the sustain voltage corresponding to the second discharging path.

It should be noted that there are two discharging paths in the ESD protection circuit 10, and the two discharging paths correspond to trigger voltages and maintenance voltages, both of which are different for the two discharging paths. Therefore, different discharging paths can be selected by the voltage at the third power supply terminal C, and the trigger voltage and the maintenance voltage can be adjusted.

The preset voltage is associated with the resistance of parasitic resistor R2. Thus, in some embodiments, the method may further include the following operation.

The resistance of the parasitic resistor is adjusted to adjust the preset voltage.

It should be noted that since the preset voltage is associated with the resistance value of the parasitic resistor R2, the voltage value of the preset voltage can be changed by adjusting the resistance of the parasitic resistor R2 to meet the demands of different scenarios.

The resistance of the parasitic resistor is associated with a length of a path between the drain 142 of the second NMOS transistor N2 and the second p+ doped region 162. Therefore, the resistance of the parasitic resistor can be changed by adjusting the length of the path.

Furthermore, the length of the path is associated with a depth of the second STI structure 172. Therefore, in some embodiments, the operation of adjusting the resistance of the parasitic resistor may include the following operation.

The depth of the second STI structure is adjusted to adjust the length of the path between the drain of the second NMOS transistor and the second p+ doped region, so that the resistance of the parasitic resistor is changed.

It should be noted that since the resistance of the parasitic resistor is associated with the length of the path between the drain 142 of the second NMOS transistor N2 and the second p+ doped region 162, and the length of the path is associated with the depth of the second STI structure 172, the resistance of the parasitic resistor can be adjusted by adjusting the depth of the second STI structure 172.

In some embodiments, the length of the path increases as the depth of the second STI structure 172 increases; and the length of the path decreases as the depth of the second STI structure 172 decreases.

It should be noted that the magnitude of the preset voltage is associated with the length of the path between the drain of the second NMOS transistor N2 and the second p+ doped region 162, and the path can be equivalent to a parasitic resistor. The longer the path, the greater the resistance of the parasitic resistor, and the greater the partial voltage of the path, the smaller the preset voltage. The depth of the second STI structure 172 affects the length of the path. The length of the path may be increased by increasing the depth of the second STI structure 172; and/or the length of the path may be decreased by decreasing the depth of the second STI structure 172, to change the resistance of the parasitic resistor and thereby changing the preset voltage.

Details not disclosed in this embodiment can be understood with reference to the description of the preceding embodiments.

The embodiments of the present disclosure provide an ESD protection method, which is applied to the ESD protection circuit of the preceding embodiment. The voltage at the second power supply terminal is acquired, when the voltage at the second power supply terminal is less than a preset voltage, the voltage at the third power supply terminal is adjusted to enable the first discharging path to be in a working state; and when the voltage at the second power supply terminal is greater than or equal to the preset voltage, the voltage at the third power supply terminal is adjusted to enable the second discharging path to be in the working state. The first discharging path represents a path formed by the channel of the second NMOS transistor and a parasitic BJT between a source and a drain of a first NMOS transistor; and the second discharging path represents the path formed by the target parasitic BJT between the source of the first NMOS transistor and the drain of the second NMOS transistor. In this way, the discharging path of ESD current can be controlled by adjusting the voltage at the second power supply terminal, so that the ESD current discharge can be realized more flexibly, and the ESD protection of the chip can be realized while the device in the circuit can be avoided from being damaged.

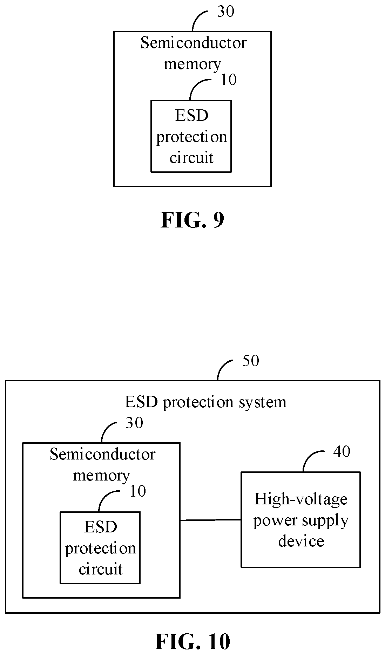

In yet another embodiment of the present disclosure, with reference to FIG. 9, a schematic structural diagram of a semiconductor memory 30 according to an embodiment of the present disclosure is shown. The semiconductor memory 30 includes an ESD protection circuit 10 as described in any of the preceding embodiments.

Since the semiconductor memory 30 includes the ESD protection circuit 10 described above, when the ESD current is generated, the ESD current can be quickly discharged to avoid damage to the semiconductor memory 30.

In yet another embodiment of the disclosure, with reference to FIG. 10, a schematic structural diagram of an ESD protection system 50 according to an embodiment of the present disclosure is shown. The ESD protection system 50 includes a high-voltage power supply device 40 and a semiconductor memory 30 as described in the foregoing embodiments. The ESD protection circuit 10 in the semiconductor memory 30 is configured to discharge the ESD current generated by the high-voltage power supply device 40.

It should be noted that the high-voltage power supply device 40 may be connected to a second power supply terminal B of the ESD protection circuit 10 in the semiconductor memory 30, and the ESD protection circuit 10 can withstand the ESD current generated by a high voltage. Therefore, in the ESD protection system 50, when an ESD event occurs in the high-voltage power supply device 40 and large ESD current is generated to apply to the semiconductor memory 30, the ESD protection circuit 10 can discharge the ESD current generated by the high-voltage power supply device to avoid damage to the semiconductor memory 30.

That is to say, since the ESD protection system 50 includes the semiconductor memory 30 including the ESD protection circuit 10, when the high-voltage power supply device 40 is likely to damage the semiconductor memory 30, the ESD protection circuit 10 can rapidly discharge the ESD current generated by the high-voltage power supply device 40, thereby realizing ESD protection of the high-voltage power supply and avoiding damage to the semiconductor memory 30.

The foregoing are only preferred embodiments of the present disclosure and are not intended to limit the scope of protection of the present disclosure.

It is to be noted that, in this disclosure, the terms "includes", "including" or any other variation thereof, are intended to cover a non-exclusive inclusion, such that a process, method, article, or device that includes a list of elements includes not only those elements but also other elements not expressly listed, or also includes elements inherent to such process, method, article, or device. Without more limitations, an element is defined by the statement "including a..." that does not rule out there are additional identical elements in a process, method, article, or apparatus that includes the element.

The above-described embodiments of the present disclosure are for the purpose of description only and do not represent the advantages or disadvantages of the embodiments.

The methods disclosed in the method embodiments provided in this disclosure can be arbitrarily combined without conflict to obtain new method embodiments.

The features disclosed in the product embodiments provided in this disclosure can be arbitrarily combined without conflict to obtain new product embodiments.

The features disclosed in the method or apparatus embodiments provided in this disclosure can be arbitrarily combined without conflict to obtain new method embodiments or apparatus embodiments.

The above is only the specific embodiments of the disclosure, but the scope of protection of the disclosure is not limited to this. Any person skilled in the technical field who can easily think of change or replacement within the technical scope of the disclosure shall be covered in the scope of protection of the disclosure. Therefore, the protection scope of the disclosure shall be subject to the protection scope of the claims.

### INDUSTRIAL APPLICABILITY

Embodiments of the present disclosure provide an ESD protection circuit, an ESD protection method, a semiconductor memory and an ESD protection system. The ESD protection circuit includes a p-type substrate; a p-type well formed on the p-type substrate; a first NMOS transistor and a second NMOS transistor formed in the p-type well, where a drain of the first NMOS transistor is connected to a source of the second NMOS transistor; and a LDD region formed in proximity to a source of the first NMOS transistor. In this way, because the drain of the first NMOS transistor is connected to the source of the second NMOS transistor, the two NMOS transistors have a common active region, which is beneficial to the discharge of the ESD current. Moreover, the parasitic BJT can be triggered to be turned on through the substrate in the ESD protection circuit, so that the ESD current can be discharged through the parasitic BJT, and the electrostatic discharge ability of the ESD protection circuit can be further enhanced. In addition, in the ESD protection circuit, an LDD region is arranged only in proximity to the source of the first NMOS transistor, which can also reduce the leakage current of the ESD protection circuit in static working and reduce the power consumption.

## Claims

1. An Electro-Static Discharge, ESD, protection circuit, comprising
a p-type substrate;
a p-type well formed on the p-type substrate;
a first Negative channel Metal Oxide Semiconductor, NMOS, transistor and a second NMOS transistor formed in the p-type well, wherein a drain of the first NMOS transistor is connected to a source of the second NMOS transistor; and
a Lightly Doped Drain region, **characterized in that** the Lightly Doped Drain region is formed only in proximity to a source of the first NMOS transistor.

2. The ESD protection circuit of claim 1, **characterized by** further comprising a first p+ doped region and a second p+ doped region that are formed in the p-type well, wherein the first p+ doped region is disposed in proximity to the source of the first NMOS transistor, and the second p+ doped region is disposed in proximity to a drain of the second NMOS transistor.

3. The ESD protection circuit of claim 2, **characterized by** further comprising a target parasitic Bipolar Junction Transistor, BJT, formed in the p-type well,
wherein a base of the target parasitic BJT is connected to one end of a parasitic resistor, and the other end of the parasitic resistor is connected to the second p+ doped region;
an emitter of the target parasitic BJT is connected to the drain of the second NMOS transistor; and
a collector of the target parasitic BJT is connected to the source of the first NMOS transistor.

4. The ESD protection circuit of claim 3, **characterized in that**, a first Shallow Trench Isolation, STI, structure is formed between the first p+ doped region and the source of the first NMOS transistor; and
a second STI structure is formed between the second p+ doped region and the drain of the second NMOS transistor.

5. The ESD protection circuit of claim 4, **characterized in that**, a resistance of the parasitic resistor is associated with a length of a path between the drain of the second NMOS transistor and the second p+ doped region.

6. The ESD protection circuit of claim 5, **characterized in that**, the length of the path is associated with a depth of the second STI structure.

7. The ESD protection circuit of claim 6, **characterized in that**:
when the depth of the second STI structure increases, the length of the path increases; and
when the depth of the second STI structure decreases, the length of the path decreases.

8. The ESD protection circuit of claim 3, **characterized in that**, the ESD protection circuit is provided with a first power supply terminal, a second power supply terminal and a third power supply terminal,
wherein a gate of the first NMOS transistor, the source of the first NMOS transistor, the first p+ doped region and the second p+ doped region are all connected to the first power supply terminal;
the drain of the second NMOS transistor is connected to the second power supply terminal; and
a gate of the second NMOS transistor is connected to the third power supply terminal.

9. An Electro-Static Discharge, ESD, protection method, applied to the ESD protection circuit of any one of claims 1 to 8, the method **characterized by** comprising:
acquiring a voltage at the second power supply terminal;
when the voltage at the second power supply terminal is less than a preset voltage, adjusting a voltage at the third power supply terminal to enable a first discharging path to be in a working state;
when the voltage at the second power supply terminal is greater than or equal to the preset voltage, adjusting the voltage at the third power supply terminal to enable a second discharging path to be in the working state,
wherein the first discharging path represents a path formed by a channel of the second Negative channel Metal Oxide Semiconductor, NMOS, transistor and a parasitic Bipolar Junction Transistor, BJT, between a source and a drain of a first NMOS transistor; and the second discharging path represents a path formed by the target parasitic BJT between the source of the first NMOS transistor and a drain of the second NMOS transistor.

10. The method of claim 9, **characterized by** further comprising:
adjusting a resistance value of the parasitic resistor to adjust the preset voltage.

11. The method of claim 10, **characterized in that**, adjusting the resistance value of the parasitic resistor comprises:
adjusting a depth of the second Shallow Trench Isolation, STI, structure to adjust a length of a path between the drain of the second NMOS transistor and the second p+ doped region, to enable the resistance value of the parasitic resistor to change.

12. A semiconductor memory, **characterized by** comprising the ESD protection circuit of any one of claims 1 to 8.

13. An Electro-Static Discharge, ESD, protection system, **characterized by** comprising a high-voltage power supply device and a semiconductor memory of claim 12, wherein an ESD protection circuit in the semiconductor memory is configured to discharge ESD current generated by the high-voltage power supply device.

## Patentansprüche

1. Schaltung zum Schutz gegen elektrostatische Entladung, ESD, umfassend:
ein p-Typ-Substrat;
eine auf dem p-Typ-Substrat ausgebildete p-Typ-Wanne;
einen ersten Negativkanal-Metalloxid-Halbleiter-, NMOS,-Transistor und einen zweiten NMOS-Transistor, die in der p-Typ-Wanne ausgebildet sind, wobei ein Drain des ersten NMOS-Transistors mit einer Source des zweiten NMOS-Transistors verbunden ist; und
einen leicht dotierten Drain-Bereich, **dadurch gekennzeichnet, dass** der leicht dotierte Drain-Bereich nur in der Nähe einer Source des ersten NMOS-Transistors ausgebildet ist.

2. ESD-Schutzschaltung nach Anspruch 1, **dadurch gekennzeichnet, dass** sie ferner einen ersten p+-dotierten Bereich und einen zweiten p+-dotierten Bereich umfasst, die in der p-Typ-Wanne ausgebildet sind, wobei der erste p+-dotierte Bereich in der Nähe der Source des ersten NMOS-Transistors angeordnet ist und der zweite p+-dotierte Bereich in der Nähe eines Drains des zweiten NMOS-Transistors angeordnet ist.

3. ESD-Schutzschaltung nach Anspruch 2, **dadurch gekennzeichnet, dass** sie ferner einen parasitären Ziel-Bipolartransistor, BJT, umfasst, der in der p-Typ-Wanne ausgebildet ist,
wobei eine Basis des parasitären Ziel-BJTs mit einem Ende eines parasitären Widerstands verbunden ist und das andere Ende des parasitären Widerstands mit dem zweiten p+-dotierten Bereich verbunden ist;
ein Emitter des parasitären Ziel-BJTs mit dem Drain des zweiten NMOS-Transistors verbunden ist; und
ein Kollektor des parasitären Ziel-BJTs mit der Source des ersten NMOS-Transistors verbunden ist.

4. ESD-Schutzschaltung nach Anspruch 3, **dadurch gekennzeichnet, dass** zwischen dem ersten p+-dotierten Bereich und der Source des ersten NMOS-Transistors eine erste flache Grabenisolations-, STI,-Struktur ausgebildet ist; und
eine zweite STI-Struktur zwischen dem zweiten p+-dotierten Bereich und dem Drain des zweiten NMOS-Transistors ausgebildet ist.

5. ESD-Schutzschaltung nach Anspruch 4, **dadurch gekennzeichnet, dass** ein Widerstand des parasitären Widerstands mit einer Länge eines Pfads zwischen dem Drain des zweiten NMOS-Transistors und dem zweiten p+-dotierten Bereich verbunden ist.

6. ESD-Schutzschaltung nach Anspruch 5, **dadurch gekennzeichnet, dass** die Länge des Pfades mit einer Tiefe der zweiten STI-Struktur verbunden ist.

7. ESD-Schutzschaltung nach Anspruch 6, **dadurch gekennzeichnet, dass**:
wenn die Tiefe der zweiten STI-Struktur zunimmt, die Länge des Pfades zunimmt; und
wenn die Tiefe der zweiten STI-Struktur abnimmt, die Länge des Pfades abnimmt.

8. ESD-Schutzschaltung nach Anspruch 3, **dadurch gekennzeichnet, dass** die ESD-Schutzschaltung mit einem ersten Stromversorgungsanschluss, einem zweiten Stromversorgungsanschluss und einem dritten Stromversorgungsanschluss vorgesehen ist,
wobei ein Gate des ersten NMOS-Transistors, die Source des ersten NMOS-Transistors, der erste p+-dotierte Bereich und der zweite p+-dotierte Bereich alle mit dem ersten Stromversorgungsanschluss verbunden sind;
der Drain des zweiten NMOS-Transistors mit dem zweiten Stromversorgungsanschluss verbunden ist; und
ein Gate des zweiten NMOS-Transistors mit dem dritten Stromversorgungsanschluss verbunden ist.

9. Verfahren zum Schutz gegen elektrostatische Entladung, ESD, das auf die ESD-Schutzschaltung nach einem der Ansprüche 1 bis 8 angewandt wird, wobei das Verfahren **dadurch gekennzeichnet ist, dass** es Folgendes umfasst:
Erfassen einer Spannung am zweiten Stromversorgungsanschluss;
wenn die Spannung am zweiten Stromversorgungsanschluss kleiner als eine voreingestellte Spannung ist, Einstellen einer Spannung am dritten Stromversorgungsanschluss, um zu ermöglichen, dass ein erster Entladungspfad in einem Arbeitszustand ist;
wenn die Spannung am zweiten Stromversorgungsanschluss größer oder gleich der voreingestellten Spannung ist, Einstellen der Spannung am dritten Stromversorgungsanschluss, um zu ermöglichen, dass ein zweiter Entladungspfad im Arbeitszustand ist,
wobei der erste Entladungspfad einen Pfad darstellt, der durch einen Kanal des zweiten Negativkanal-Metalloxid-Halbleiter-, NMOS,-Transistors und einen parasitären Bipolartransistor, BJT, zwischen einer Source und einem Drain eines ersten NMOS-Transistors ausgebildet ist; und der zweite Entladungspfad einen Pfad darstellt, der durch den parasitären Ziel-BJT zwischen der Source des ersten NMOS-Transistors und einem Drain des zweiten NMOS-Transistors ausgebildet ist.

10. Verfahren nach Anspruch 9, **dadurch gekennzeichnet, dass** es ferner umfasst:
Einstellen eines Widerstandswerts des parasitären Widerstands zum Einstellen der voreingestellten Spannung.

11. Verfahren nach Anspruch 10, **dadurch gekennzeichnet, dass** das Einstellen des Widerstandswerts des parasitären Widerstands umfasst:
Einstellen einer Tiefe der zweiten flachen Grabenisolations-, STI,-Struktur, um eine Länge eines Pfades zwischen dem Drain des zweiten NMOS-Transistors und dem zweiten p+-dotierten Bereich einzustellen, damit sich der Widerstandswert des parasitären Widerstands ändern kann.

12. Halbleiterspeicher, **dadurch gekennzeichnet, dass** er die ESD-Schutzschaltung nach einem der Ansprüche 1 bis 8 umfasst.

13. System zum Schutz gegen elektrostatische Entladung, ESD, **dadurch gekennzeichnet, dass** es eine Hochspannungs-Stromversorgungsvorrichtung und einen Halbleiterspeicher nach Anspruch 12 umfasst, wobei eine ESD-Schutzschaltung im Halbleiterspeicher konfiguriert ist, um den von der Hochspannungs-Stromversorgungsvorrichtung erzeugten ESD-Strom zu entladen.

## Revendications

1. Circuit de protection contre les décharges électrostatiques, ESD, comprenant :
un substrat de type p ;
un puits de type p formé sur le substrat de type p ;
un premier transistor semi-conducteur a oxyde métallique à canal négatif, NMOS, et un deuxième transistor NMOS formés dans le puits de type p, dans lequel un drain du premier transistor NMOS est connecté à une source du deuxième transistor NMOS ; et
une région de drainage légèrement dopée, **caractérisé en ce que** la région de drainage légèrement dopée est formée uniquement à proximité d'une source du premier transistor NMOS.

2. Circuit de protection ESD de la revendication 1, **caractérisé en ce qu'**il comprend en outre une première région dopée p+ et une deuxième région dopée p+ qui sont formées dans le puits de type p, dans lequel la première région dopée p+ est disposée à proximité de la source du premier transistor NMOS, et la deuxième région dopée p+ est disposée à proximité d'un drain du deuxième transistor NMOS.

3. Circuit de protection ESD de la revendication 2, caractérisé en comprenant en outre un transistor à jonction bipolaire, BJT, parasite cible forme dans e puits de type p,
dans lequel une base du BJT parasite cible est connectée à une extrémité d'une résistance parasite, et l'autre extrémité de la résistance parasite est connectée à la deuxième région dopée p+ ;
un émetteur du BJT parasite cible est connecté au drain du deuxième transistor NMOS ; et
un collecteur du BJT parasite cible est connecté à la source du premier transistor NMOS.

4. Circuit de protection ESD de la revendication 3, **caractérisé en ce qu'**une première structure d'isolation de tranchée peu profonde, STI, est formée entre la première région dopée p+ et la source du premier transistor NMOS ; et
une deuxième structure STI est formée entre la deuxième région dopée p+ et le drain du deuxième transistor NMOS.

5. Circuit de protection ESD de la revendication 4, **caractérisé en ce qu'**une résistance de la résistance parasite est associée à une longueur d'un chemin entre le drain du deuxième transistor NMOS et la deuxième région dopée p+.

6. Circuit de protection ESD de la revendication 5, **caractérisé en ce que** la longueur du chemin est associée à une profondeur de la deuxième structure STI.

7. Circuit de protection ESD de la revendication 6, **caractérisé en ce que** :
lorsque la profondeur de la deuxième structure STI augmente, la longueur du chemin augmente ; et
lorsque la profondeur de la deuxième structure STI diminue, la longueur du chemin diminue.

8. Circuit de protection ESD de la revendication 3, **caractérisé en ce que** le circuit de protection ESD est pourvu d'une première borne d'alimentation, d'une deuxième borne d'alimentation et d'une troisième borne d'alimentation,
dans lequel une grille du premier transistor NMOS, la source du premier transistor NMOS, la première région dopée p+ et la deuxième région dopée p+ sont toutes connectées à la première borne d'alimentation ;
le drain du deuxième transistor NMOS est connecté à la deuxième borne d'alimentation ; et
une grille du deuxième transistor NMOS est connectée à la troisième borne d'alimentation.

9. Procédé de protection contre les décharges électrostatiques, ESD, appliqué au circuit de protection ESD de l'une quelconque des revendications 1 à 8, le procédé étant caractérisé en comprenant :
acquérir une tension au niveau de la deuxième borne d'alimentation ;
lorsque la tension au niveau de la deuxième borne d'alimentation est inférieure à une tension prédéfinie, ajuster une tension au niveau de la troisième borne d'alimentation pour permettre à un premier chemin de décharge d'être dans un état de travail ;;
lorsque la tension au niveau de la deuxième borne d'alimentation est supérieure ou égale à la tension prédéfinie, ajuster la tension au niveau de la troisième borne d'alimentation pour permettre à un deuxième chemin de décharge d'être à l'état de travail,
dans lequel le premier chemin de décharge représente un chemin formé par un canal du deuxième transistor semi-conducteur a oxyde métallique à canal négatif, NMOS, et un transistor à jonction bipolaire, BJT, parasite entre une source et un drain d'un premier transistor NMOS; et le deuxième chemin de décharge représente un chemin formé par le BJT parasite cible entre la source du premier transistor NMOS et un drain du deuxième transistor NMOS.

10. Procédé de la revendication 9, caractérisé en comprenant en outre :
régler une valeur de résistance de la résistance parasite pour ajuster la tension prédéfinie.

11. Procédé de la revendication 10, **caractérisé en ce que** le réglage de la valeur de résistance de la résistance parasite comprend :
régler la profondeur de la deuxième structure d'isolation de tranchée peu profonde, STI, pour régler la longueur d'un chemin entre le drain du deuxième transistor NMOS et la deuxième région dopée p+, afin de permettre à la valeur de résistance de la résistance parasite de changer.

12. Mémoire à semi-conducteur, caractérisée en comprenant le circuit de protection ESD de l'une quelconque des revendications 1 à 8.

13. Système de protection contre les décharges électrostatiques, ESD, caractérisé en comprenant un dispositif d'alimentation à haute tension et une mémoire à semi-conducteur selon la revendication 12, dans lequel un circuit de protection ESD dans la mémoire à semi-conducteur est configuré pour décharger le courant d'ESD généré par le dispositif d'alimentation à haute tension.
